# FASCICULE DE BREVET EUROPEEN

(11) **EP 3 977 520 B1**
(45) Date de publication et mention de la délivrance du brevet: **08.03.2023**
(21) Numéro de dépôt: 20739752.2
(22) Date de dépôt: 25.05.2020
(51) Int. Cl.: H01L 31/0224, H01L 31/18

(54) **PROCEDE DE RECYCLAGE DE L'ARGENT PRESENT SUR UNE CELLULE PHOTOVOLTAÏQUE**
VERFAHREN ZUR RÜCKGEWINNUNG VON SILBER AUF EINER FOTOVOLTAISCHEN ZELLE
METHOD FOR RECYCLING SILVER PRESENT ON A PHOTOVOLTAIC CELL

(30) Priorité: 29.05.2019 FR 1905739
(43) Date de publication de la demande: 06.04.2022
(73) Titulaire: ROSI, 38000 Grenoble (FR)
(72) Inventeur: LUO, Yun, 3054 Schupfen (CH)
(74) Mandataire: IP Trust
(86) Numéro de dépôt international: PCT/FR2020/050869
(87) Numéro de publication internationale: WO 2020/240126

(56) Documents cités:
- CN-A- 105 355 541
- KR-A- 20160 027 325
- KR-B1- 101 539 528
- US-A1- 2018 291 477
- Anonymous: "Pure 999 silver electrodes 2 strips 11cm x 2,5 mm for: Amazon.co.uk: Electronics", , 26 avril 2017 (2017-04-26), XP055675486, Extrait de l'Internet: URL:https://www.amazon.co.uk/silver-electr odes-strips-production-colloidal/dp/B06ZZ2 HGSP [extrait le 2020-03-10]

## Description

### DOMAINE DE L'INVENTION

La présente invention concerne le domaine des modules solaires et des composants microélectroniques. Elle concerne en particulier un procédé de recyclage de l'argent présent sur une cellule photovoltaïque.

### ARRIERE PLAN TECHNOLOGIQUE DE L'INVENTION

L'argent est le matériau présentant le plus de valeur dans les modules solaires. En effet, dans les cellules photovoltaïques, le réseau métallique de collection des charges électriques générées par l'énergie solaire est habituellement formé par de fines lignes d'argent de dizaines de microns d'épaisseur. On peut estimer que, dans des modules solaires en fin de vie correspondant à une puissance de 1 MWatt, la valeur du matériau argent est aujourd'hui de l'ordre de 25k$.

Beaucoup de méthodes proposées pour l'extraction de l'argent des modules solaires et son recyclage sont basées sur une voie hydro-métallurgique, qui implique une dissolution complète de l'argent suivie, soit par sa transformation sous forme de complexe dans un sel, soit par un dépôt sous forme de métal pur.

Le solvant le plus utilisé pour dissoudre l'argent est l'acide nitrique, comme décrit notamment dans les documents DE102007034441 et CN105355541. Le document US2016053343 propose une variante basée sur la réaction de l'argent avec de l'acide sulfonique en présence d'un agent oxydant. Une autre variante énoncée par le document WO2015130607 consiste à dissoudre l'argent en utilisant une solution composée d'un agent oxydant, d'halogénure, d'acide et de solvant.

Bien-sûr, ce ne sont là que quelques exemples de méthodes, d'autres méthodes basées sur la dissolution de l'argent existent. Dans tous les cas, le processus global est généralement long et complexe car il requiert de passer de la forme solide de l'argent à sa forme liquide, puis de nouveau à sa forme solide.

Alternativement, certaines méthodes, comme divulgué par le document US2017092528, prévoient le pelage de couches métalliques superficielles par adhésion et transfert sur un ruban adhésif. Les couches métalliques sont ensuite séparées de l'adhésif dans une solution liquide. Le document KR20160027325 divulgue un procédé de récupération de l'argent d'une cellule photovoltaïque par dissolution.

### OBJET DE L'INVENTION

La présente invention propose une solution alternative à celles de l'état de la technique. Elle concerne un procédé simple et économique de recyclage de l'argent présent sur les cellules photovoltaïques.

### BREVE DESCRIPTION DE L'INVENTION

L'invention concerne un procédé de recyclage de l'argent présent sur une cellule photovoltaïque, comprenant :
- une étape a) de fourniture d'une cellule photovoltaïque comportant :
   o un substrat support en silicium présentant une face avant et une face arrière,
   o une couche supérieure en silicium dopé, de type de dopage opposé à celui du substrat support, disposée sur la face avant,
   o une pluralité de lignes d'argent disposées sur la couche supérieure,
   o au moins une couche anti-réflective disposée sur la couche supérieure, adjacente aux lignes d'argent,
- une étape b) de gravure de la couche anti-réflective par immersion de la cellule photovoltaïque dans une solution acide,
- une étape c) de gravure de la couche supérieure par immersion de la cellule photovoltaïque dépourvue de couche anti-réflective, dans une solution basique, menant au détachement des lignes d'argent,
- une étape d) de séchage de l'ensemble formé par le substrat support et les lignes d'argent détachées,
- une étape e) d'extraction des lignes d'argent à l'état solide.

Selon d'autres caractéristiques avantageuses et non limitatives de l'invention, prises seules ou selon toute combinaison techniquement réalisable :
- les étapes b) et c) comprennent un rinçage avec de l'eau désionisée ou ultra-pure, préalablement à l'étape suivante ;
- des ultra-sons sont appliqués pendant tout ou partie des étapes b) et/ou c) à une fréquence comprise entre 40kHz et 100 kHz, avantageusement de 80kHz,
- la solution acide utilisée à l'étape b) est de l'acide fluorhydrique présentant une concentration comprise entre 0,5% et 48%, avantageusement comprise entre 0,5% et 5% ;
- la solution basique utilisée à l'étape c) est de l'hydroxyde de sodium présentant une concentration comprise entre 1 et 30%, avantageusement à 3% ;
- la gravure de l'étape c) est opérée à une température comprise entre 20°C et 100°C, avantageusement à 50°C ;
- l'étape e) d'extraction se fait par différence de densité ou par tamisage, pour séparer les lignes d'argent et le substrat support ;
- l'extraction par différence de densité est basée sur une méthode de soufflerie ou de vibration ;
- la cellule photovoltaïque comporte :
   o une couche inférieure en silicium dopé, du même type de dopage que le substrat support, disposée sur la face arrière dudit substrat support,
   o une couche intercalaire d'un alliage de silicium et d'aluminium disposée sur la couche inférieure,
   o une couche de contact arrière en aluminium ;
- l'étape b) du procédé grave ou désagrège la couche de contact arrière ;
- l'étape c) du procédé grave la couche intercalaire et la couche inférieure ;
- le procédé de recyclage comprend, après l'étape e), une étape f) de réutilisation du substrat support.

L'invention concerne également les lignes d'argent sous forme solide, issues du procédé de recyclage précité.

L'invention concerne en outre l'utilisation desdites lignes d'argent pour la fabrication d'une colle conductrice à base d'argent et/ou pour la fabrication d'électrodes d'argent ou d'électrolyte pour un dépôt électrolytique.

### BREVE DESCRIPTION DES FIGURES

D'autres caractéristiques et avantages de l'invention ressortiront de la description détaillée de l'invention qui va suivre en référence aux figures annexées sur lesquelles :

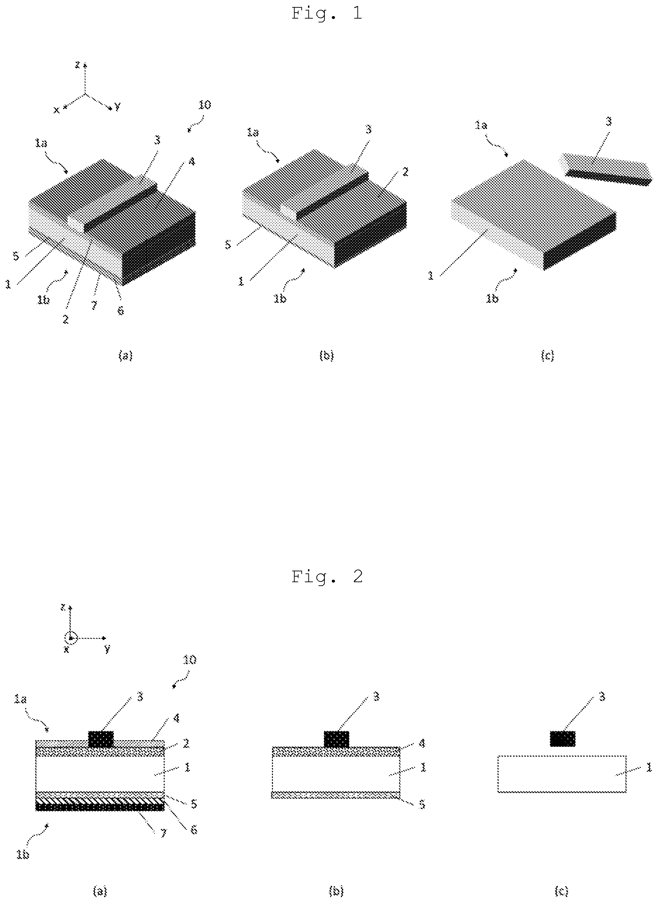

Les figures 1 et 2 présentent des étapes du procédé de recyclage conforme à l'invention.

### DESCRIPTION DETAILLEE DE L'INVENTION

Dans la partie descriptive, les mêmes références sur les figures pourront être utilisées pour des éléments de même type. Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y ; et les épaisseurs relatives des couches entre elles ne sont pas nécessairement respectées sur les figures.

La présente invention concerne un procédé de recyclage de l'argent présent sur une cellule photovoltaïque.

Dans la présente invention, on entend par cellule photovoltaïque un composant à base de silicium comprenant :
- les couches semi-conductrices requises pour former une jonction PN apte à transformer l'énergie lumineuse en charges électriques,
- les couches métalliques requises pour collecter lesdites charges et former les contacts aux bornes desquels s'établira une différence de potentiel, et
- au moins une couche anti-réflective disposée sur la face destinée à être illuminée, permettant de limiter les pertes par réflexion du rayonnement solaire.

Le procédé de recyclage selon l'invention comprend une première étape a) de fourniture d'une cellule photovoltaïque 10 (figure 1 (a) et figure 2 (a)). Celle-ci comprend un substrat support 1 en silicium, faiblement dopé, présentant une face avant 1a et une face arrière 1b. Le niveau de dopage (de type P habituellement, mais pouvant éventuellement être de type N) est typiquement autour de 10¹⁶ cm⁻³ correspondant à une résistivité autour de 1 ohm.cm.

La cellule photovoltaïque 10 comprend également une couche supérieure 2 en silicium dopé disposée sur la face avant 1a du substrat support 1. En particulier, la couche supérieure 2 présente un type de dopage opposé à celui du substrat support 1. La résistivité de la couche supérieure 2 est typiquement autour de 75 ohms/sq. Par exemple, si le substrat support 1 est dopé de type P (dopage Bore), la couche supérieure 2 est de type N (dopage Phosphore). Elle forme, avec le substrat support 1, une jonction PN, pour séparer les charges de polarité inverses (électrons et trous) lorsque celles-ci sont générées dans la cellule 10 sous illumination. La couche supérieure 2 présente typiquement une épaisseur de moins que 1 micron.

Avantageusement, une couche inférieure 5 en silicium fortement dopé, du même type de dopage que le substrat support 1, est disposée sur la face arrière 1b du substrat support 1. La couche inférieure 5 présente par exemple une épaisseur autour de 5 microns avec une concentration maximale en dopants de l'ordre de 3×10¹⁸ cm⁻³ à 4×10¹⁸ cm⁻³.

La cellule photovoltaïque 10 comprend en outre une pluralité de lignes d'argent 3 disposées sur la couche supérieure 2. Ces lignes d'argent constituent les contacts métalliques pour collecter les charges générées dans la structure semi-conductrice sous-jacente et sont réparties de manière relativement uniforme sur la couche supérieure 2. Elles sont en général composées d'alliage d'argent comprenant entre 93% et 97% d'argent. Sans que cela soit limitatif, ces lignes d'argent 3 pourront présenter une épaisseur autour de 20 microns, une largeur d'environ 100 microns, et être espacées d'une distance typiquement de 2mm.

Avantageusement, la cellule photovoltaïque 10 comprend également un ou des contacts du côté de la face arrière 1b du substrat support 1. En particulier, une couche de contact arrière 7 en aluminium est habituellement disposée sur la couche inférieure 5. A titre d'exemple, cette couche de contact arrière 7 peut présenter une épaisseur de l'ordre d'une à quelques dizaine(s) de microns.

Du fait de la diffusion de l'aluminium dans le silicium durant les traitements thermiques d'élaboration de la cellule 10, une couche intercalaire 6, alliage de silicium et d'aluminium, peut être présente entre la couche inférieure en silicium 5 et la couche de contact arrière 7. L'épaisseur de la couche intercalaire 6 pourra par exemple varier autour de 10 microns.

Lorsqu'un rayonnement solaire est projeté sur une telle cellule photovoltaïque 10 fonctionnelle, les charges de polarité opposée, générées dans la structure semi-conductrice, sont respectivement collectées sur les pistes d'argent 3 et sur la couche de contact arrière 7, fournissant une différence de potentiel entre ces deux contacts métalliques.

La cellule photovoltaïque 10 comprend également au moins une couche anti-réflective 4 disposée sur la couche supérieure 2, adjacente aux lignes d'argent 3. Habituellement, la couche anti-réflective est formée en nitrure de silicium (SiN) ou encore en oxyde de titane. Dans le cas de nitrure de silicium, elle présente une épaisseur de l'ordre de 75nm.

Bien-sûr, le présent procédé étant destiné à recycler une cellule photovoltaïque 10, il vise à traiter des cellules en fin de vie, des cellules défectueuses, ou des cellules issues de modules solaires hors spécifications (rejets de production).

Le procédé de recyclage selon l'invention comprend ensuite une étape b) de gravure de la couche anti-réflective 4 par immersion de la cellule 10 dans une solution acide (figure 1 (b) et figure 2 (b)). Ladite solution acide pourra être choisie selon la nature de la couche anti-réflective 4. En particulier, pour une couche anti-réflective 4 en nitrure de silicium, la solution acide est de l'acide fluorhydrique (HF) présentant une concentration comprise entre 0,5% et 48%. De manière préférentielle, la concentration en HF est comprise entre 0,5% et 5%. Le temps de gravure, par exemple pour une couche de SiN de 75nm, est d'environ 10 min. Le temps de gravure pourra évidemment varier en fonction de la concentration de la solution acide et en fonction de l'épaisseur de la couche anti-réflective 4.

Alternativement, la solution acide pourra comprendre un mélange d'acide fluorhydrique avec du peroxyde d'hydrogène.

La couche de contact arrière 7 est avantageusement gravée et/ou désagrégée par la solution acide au cours de l'étape b). Dans le cas d'une gravure HF, la couche de contact arrière 7 en aluminium va se détacher et se désagréger dans la solution. Les résidus d'aluminium, sous forme de film en suspension sont évacués lors du rinçage qui termine cette étape b).

La gravure de l'étape b) est suivie d'un rinçage à l'eau désionisée ou ultra-pure, avant réalisation de l'étape suivante. Le rinçage pourra avantageusement être effectué par débordement du bain dans lequel la cellule 10, dépourvue de sa couche anti-réflective 4, est immergée.

De manière avantageuse, la gravure de l'étape b) est effectuée alors que des ultra-sons sont appliqués à une fréquence comprise entre 40kHz et 100 kHz. Les ultra-sons améliorent l'efficacité de la gravure de la couche anti-réflective 4 et favorisent le détachement de la couche de contact arrière 7. Les ultra-sons peuvent également initier le détachement local des lignes d'argent 3. Préférentiellement la fréquence des ultra-sons est choisie à 80kHz, pour éviter la casse de lignes d'argent 3 lors de l'initiation de leur détachement.

Le procédé de recyclage selon l'invention comprend ensuite une étape c) de gravure de la couche supérieure 2 par immersion de la cellule 10 dépourvue de sa couche anti-réflective 4 (et éventuellement dépourvue de sa couche de contact arrière 7), dans une solution basique : la gravure de la couche supérieure 2 mène au détachement des lignes d'argent 3 du substrat support 1 (figure 1 (c) et figure 2 (c)).

La solution basique utilisée pour la gravure de l'étape c) est préférentiellement de l'hydroxyde de sodium (NaOH) présentant une concentration comprise entre 1 et 30%. Cette solution est avantageuse en ce qu'elle présente une vitesse de gravure facilement contrôlable. Par exemple, pour une concentration de NaOH à 3%, la vitesse de gravure est de l'ordre de 0.5 microns/min à 50°C. Elle présente en outre une bonne sélectivité vis-à-vis de l'argent : les lignes d'argent 3 ne sont donc pas dégradées pendant cette étape de gravure.

Alternativement, une solution de TMAH (Tetramethylammonium hydroxide) peut être utilisée pour graver la couche supérieure 2.

La gravure de l'étape c) est opérée à une température comprise entre 20°C et 100°C, préférentiellement à 50°C. Cela permet notamment d'atteindre des vitesses de gravure plus importantes. Selon l'épaisseur de la couche supérieure 2, la gravure pourra présenter une durée comprise entre quelques minutes et une heure.

Avantageusement, la couche intercalaire 6 en siliciure d'aluminium est également gravée par la solution basique au cours de l'étape c), en particulier dans le cas d'une gravure NaOH.

Selon un mode de mise en oeuvre avantageux, des ultra-sons sont appliqués pendant tout ou partie de l'étape c) à une fréquence comprise entre 40kHz et 100 kHz, pour augmenter l'efficacité de la gravure et le détachement des lignes d'argent 3. Préférentiellement, cette fréquence est définie à 80kHz pour limiter la casse des lignes d'argent 3, destinées à être totalement détachées et libres dans la solution au terme de l'étape c).

La gravure de l'étape c) est suivie d'un rinçage à l'eau désionisée ou ultra-pure, avant réalisation de l'étape suivante. Le rinçage pourra avantageusement être effectué par débordement du bain dans lequel sont immergés le substrat support 1 et les lignes d'argent 3 libres (c'est-à-dire détachées du substrat support 1).

L'étape d) suivante du procédé de recyclage comprend le séchage de l'ensemble formé par le substrat support 1 et les lignes d'argent 1 détachées. Ce séchage est préférentiellement effectué de façon statique, par exemple dans une étuve à une température légèrement supérieure à la température ambiante.

Enfin, le procédé de recyclage selon l'invention comprend une étape e) d'extraction des lignes d'argent 3 à l'état solide. Avantageusement, cette étape d'extraction se fait par différence de densité. Cette étape peut être basée sur une méthode connue de soufflerie ou de vibration, apte à séparer physiquement les lignes d'argent 3 libres et le substrat support 1. Dans certains cas, un procédé de tamisage permet aussi une séparation efficace des lignes d'argent 3 et du substrat support 1.

Le procédé de recyclage des lignes d'argent 3 selon l'invention est particulièrement avantageux par rapport aux techniques de l'état de l'art en ce qu'il est simple de mise en oeuvre et que la quantité d'argent est quasiment intégralement récupérée, les lignes 3 n'étant pas ou très peu dégradées au cours des étapes.

La présente invention porte également sur les lignes d'argent 3 libres, sous forme solide, issus du procédé de recyclage précité. Par lignes d'argent sous forme solide, on entend ici les lignes d'argent intègres et entières, ainsi que les fragments de lignes d'argent, tous issus dudit procédé.

Ces lignes d'argent 3 ou fragments peuvent être utilisés pour la fabrication de colles conductrices à base d'argent. A cet effet, on pourra par exemple les mélanger avec un ou plusieurs ingrédients polymères et/ou autres composés.

Les lignes d'argent 3 ou fragments peuvent également servir à la fabrication d'électrodes d'argent (sous forme solide) ou d'électrolyte (dissous en solution) destinés à la réalisation de dépôt électrolytique.

Le procédé de recyclage selon l'invention peut en outre comprendre une étape f) de réutilisation du substrat support 2. En effet, après l'étape e) comprenant la séparation physique entre les lignes d'argent 3 libres et le substrat support 1, les faces avant et arrière de ce dernier peuvent être totalement dépourvues de couches dopées (couche supérieure 2, couche inférieure 5), de couches métalliques ou d'alliage (lignes d'argent 3, couche de contact arrière 7, couche intercalaire 6) et de couche anti-réflective 4. Le substrat support 1 extrait de l'étape e) présente un très bon niveau de pureté. Il pourra ainsi être réintroduit dans une filière silicium, par exemple, pour la production de Trichlorosilane (TCS) ou de silicium « feedstock » par DSS (Directional Ségrégation System).

Bien entendu, l'invention n'est pas limitée aux modes de réalisation et aux exemples décrits, et on peut y apporter des variantes de réalisation sans sortir du cadre de l'invention tel que défini par les revendications.

## Revendications

1. Procédé de recyclage de l'argent présent sur une cellule photovoltaïque (10), comprenant :
- une étape a) de fourniture d'une cellule photovoltaïque (10) comportant :
- un substrat support (1) en silicium présentant une face avant (1a) et une face arrière (1b),
- une couche supérieure (2) en silicium dopé, de type de dopage opposé à celui du substrat support (1), disposée sur la face avant (1a) ,
- une pluralité de lignes d'argent (3) disposées sur la couche supérieure (2),
- au moins une couche anti-réflective (4) disposée sur la couche supérieure (2), adjacente aux lignes d'argent (3) ,
- une étape b) de gravure de la couche anti-réflective (4) par immersion de la cellule photovoltaïque (10) dans une solution acide,
- une étape c) de gravure de la couche supérieure (2) par immersion de la cellule photovoltaïque dépourvue de couche anti-réflective, dans une solution basique, menant au détachement des lignes d'argent (3),
- une étape d) de séchage de l'ensemble formé par le substrat support (1) et les lignes d'argent (3) détachées,
- une étape e) d'extraction des lignes d'argent (3) à l'état solide.

2. Procédé de recyclage selon la revendication précédente, dans lequel les étapes b) et c) comprennent un rinçage avec de l'eau désionisée ou ultra-pure, préalablement à l'étape suivante.

3. Procédé de recyclage selon l'une des revendications précédentes, dans lequel des ultra-sons sont appliqués pendant tout ou partie des étapes b) et/ou c) à une fréquence comprise entre 40kHz et 100 kHz, avantageusement de 80kHz.

4. Procédé de recyclage selon l'une des revendications précédentes, dans lequel la solution acide utilisée à l'étape b) est de l'acide fluorhydrique présentant une concentration comprise entre 0,5% et 48%, avantageusement comprise entre 0,5% et 5%.

5. Procédé de recyclage selon l'une des revendications précédentes, dans lequel la solution basique utilisée à l'étape c) est de l'hydroxyde de sodium présentant une concentration comprise entre 1 et 30%, avantageusement à 3*%*.

6. Procédé de recyclage selon la revendication précédente, dans lequel la gravure de l'étape c) est opérée à une température comprise entre 20°C et 100°C, avantageusement à 50°C.

7. Procédé de recyclage selon l'une des revendications précédentes, dans lequel l'étape e) d'extraction se fait par différence de densité ou par tamisage, pour séparer les lignes d'argent (3) et le substrat support (1).

8. Procédé de recyclage selon la revendication précédente, dans lequel l'extraction par différence de densité est basée sur une méthode de soufflerie ou de vibration.

9. Procédé de recyclage selon l'une des revendications précédentes, comprenant, après l'étape e), une étape f) de réutilisation du substrat support (1).

10. Procédé de recyclage selon l'une des revendications précédentes, dans lequel les lignes d'argent (3) issues de l'étape e) sont utilisées pour la fabrication d'une colle conductrice à base d'argent et/ou pour la fabrication d'électrodes d'argent ou d'électrolyte pour un dépôt électrolytique.

## Patentansprüche

1. Verfahren zum Recyceln von Silber, das auf einer Photovoltaikzelle (10) vorliegt, umfassend:
- einen Schritt a) eines Bereitstellens einer Photovoltaikzelle (10), die aufweist:
- ein Siliziumträgersubstrat (1), das eine Vorderseite (1a) und eine Rückseite (1b) vorweist,
- eine obere Schicht (2) aus dotiertem Silizium von einem Dotierungstyp, der dem des Trägersubstrats (1) entgegengesetzt ist, das auf der Vorderseite (1a) angeordnet ist,
- eine Vielzahl von Silberlinien (3), die auf der oberen Schicht (2) angeordnet sind,
- mindestens eine Antireflexionsschicht (4), die auf der oberen Schicht (2) angrenzend an die Silberlinien (3) angeordnet ist,
- einen Schritt b) eines Ätzens der Antireflexionsschicht (4) durch Eintauchen der Photovoltaikzelle (10) in eine saure Lösung,
- einen Schritt c) des Ätzens der oberen Schicht (2) durch Eintauchen der Photovoltaikzelle ohne Antireflexionsschicht in eine basische Lösung, was zu dem Ablösen der Silberlinien (3) führt,
- einen Schritt d) eines Trocknens der Baugruppe, die durch das Trägersubstrat (1) und die abgelösten Silberlinien (3) ausgebildet ist,
- einen Schritt e) eines Extrahierens der Silberlinien (3) in dem festen Zustand.

2. Recyclingverfahren nach dem vorstehenden Anspruch, wobei die Schritte b) und c) vor dem folgenden Schritt ein Spülen mit deionisiertem oder hochreinem Wasser umfassen.

3. Recyclingverfahren nach einem der vorstehenden Ansprüche, wobei während allen oder einem Teil der Schritte b) und/oder c) Ultraschall mit einer Frequenz zwischen 40 kHz und 100 kHz, vorteilhafterweise 80 kHz, angewendet wird.

4. Recyclingverfahren nach einem der vorstehenden Ansprüche, wobei die in Schritt b) verwendete saure Lösung Flusssäure ist, die eine Konzentration zwischen 0,5 % und 48 %, vorteilhafterweise zwischen 0,5 % und 5 %, vorweist.

5. Recyclingverfahren nach einem der vorstehenden Ansprüche, wobei die in Schritt c) verwendete basische Lösung Natriumhydroxid ist, das eine Konzentration zwischen 1 und 30 %, vorteilhafterweise von 3 %, vorweist.

6. Recyclingverfahren nach dem vorstehenden Anspruch, wobei das Ätzen von Schritt c) bei einer Temperatur zwischen 20 °C und 100 °C, vorteilhafterweise bei 50 °C, vorgenommen wird.

7. Recyclingverfahren nach einem der vorstehenden Ansprüche, wobei Schritt e) des Extrahierens durch einen Dichteunterschied oder durch Sieben zum Trennen der Silberlinien (3) und des Trägersubstrats (1) durchgeführt wird.

8. Recyclingverfahren nach dem vorstehenden Anspruch, wobei das Extrahieren durch den Dichteunterschied auf einer Gebläse- oder Vibrationstechnik basiert.

9. Recyclingverfahren nach einem der vorstehenden Ansprüche, umfassend nach Schritt e) einen Schritt f) einer Wiederverwendung des Trägersubstrats (1).

10. Recyclingverfahren nach einem der vorstehenden Ansprüche, wobei die aus Schritt e) entstandenen Silberlinien (3) für die Herstellung eines leitfähigen Klebers auf Silberbasis und/oder für die Herstellung von Silber- oder Elektrolytelektroden für eine Metallabscheidung verwendet werden.

## Claims

1. Method for recycling silver present on a photovoltaic cell (10), comprising:
- a step a) of supplying a photovoltaic cell (10) including:
- a silicon support substrate (1) having a front face (1a) and a rear face (1 b),
- an upper layer (2) of doped silicon, of a doping type opposite to that of the support substrate (1), which layer is arranged on the front face (1a),
- a plurality of silver lines (3) arranged on the upper layer (2),
- at least one anti-reflective layer (4) arranged on the upper layer (2) and adjacent to the silver lines (3);
- a step b) of etching the anti-reflective layer (4) by immersing the photovoltaic cell (10) in an acid solution;
- a step c) of etching the upper layer (2) by immersing, in a basic solution, the photovoltaic cell without the anti-reflective layer, leading to separation of the silver lines (3);
- a step d) of drying the assembly formed by the support substrate (1) and the separated silver lines (3);
- a step e) of extracting the silver lines (3) in the solid state.

2. Recycling method according to the preceding claim, wherein steps b) and c) comprise rinsing with deionized or ultra-pure water prior to the subsequent step.

3. Recycling method according to either of the preceding claims, wherein ultrasound is applied during all or part of steps b) and/or c) at a frequency of between 40 kHz and 100 kHz, advantageously 80 kHz.

4. Recycling method according to any of the preceding claims, wherein the acid solution used in step b) is hydrofluoric acid having a concentration of between 0.5% and 48%, advantageously between 0.5% and 5%.

5. Recycling method according to any of the preceding claims, wherein the basic solution used in step c) is sodium hydroxide having a concentration of between 1 and 30%, advantageously 3%.

6. Recycling method according to the preceding claim, wherein etching step c) is carried out at a temperature of between 20°C and 100°C, advantageously at 50°C.

7. Recycling method according to any of the preceding claims, wherein extracting step e) is carried out by density difference or by sieving in order to separate the silver lines (3) and the support substrate (1).

8. Recycling method according to the preceding claim, wherein extraction by density difference is based on a blower or vibration technique.

9. Recycling method according to any of the preceding claims, comprising, after step e), a step f) of reusing the support substrate (1).

10. Recycling method according to any of the preceding claims, wherein the silver lines (3) resulting from step e) are used for producing a conductive silver-based adhesive and/or for producing silver electrodes or electrolyte electrodes for electrolytic deposition.
